# EUROPEAN PATENT SPECIFICATION

(11) **EP 3 391 419 B1**
(45) Date of publication and mention of the grant of the patent: **26.11.2025**
(21) Application number: 16825915.8
(22) Date of filing: 19.12.2016
(51) Int. Cl.: H10F 10/19, H10F 19/40, H10F 71/00, H10F 77/20, H10K 30/10, H10K 30/83, H10K 85/50

(54) **TANDEM SOLAR CELL AND METHOD FOR MANUFACTURING SUCH A SOLAR CELL**
TANDEMSOLARZELLE UND VERFAHREN ZUR HERSTELLUNG SOLCH EINER SOLARZELLE
CELLULE SOLAIRE TANDEM ET PROCÉDÉ DE FABRICATION D'UNE TELLE CELLULE SOLAIRE

(30) Priority: 18.12.2015 NL 2015987
(43) Date of publication of application: 24.10.2018
(73) Proprietor: Nederlandse Organisatie voor toegepast- natuurwetenschappelijk Onderzoek TNO, 2595 DA 's-Gravenhage (NL)
(72) Inventor: VAN ROOSMALEN, Johannes Adrianus Maria, 1755 LE Petten (NL); VEENSTRA, Siegfried Christiaan, 1755 LE Petten (NL); ZHANG, Dong, 1755 LE Petten (NL); GEERLIGS, Lambert Johan, 1755 LE Petten (NL); SCHROPP, Rudolf Emmanuel Isidore, 1755 LE Petten (NL)
(74) Representative: Nederlandsch Octrooibureau
(86) International application number: PCT/NL2016/050891
(87) International publication number: WO 2017/105247

(56) References cited:
- WO-A1-2012/026806
- WO-A1-2015/017885
- US-A1- 2015 206 997

## Description

### Field of the invention

The present invention relates to a tandem solar cell. Also, the present invention relates to a method for manufacturing such a tandem solar cell.

### Background

Tandem or more generally multi-junction solar cells consisting of a bottom silicon wafer based solar cell and a top thin film solar cell are nowadays seen as a serious contender to reach higher efficiencies for wafer based Si technologies. Tandems can have a two terminal (2T), three terminal (3T) and four terminal (4T) geometry. 3T geometry is not often considered, since the intermediate layer needs to be current transporting. For multi-junction devices, the 2T concept is generically applicable, while the 3T and 4T concepts (and combinations thereof) result incorporation of additional transparent electrodes and concomitantly terminals to the devices stack.

In tandem solar cells, a transparent electrode is present in the top cell. Most transparent conductors have poor light transmitting properties, especially at high conductivities. Although current densities in tandem devices are lower compared to single-junction devices, the trade-off between optical and electrical losses always remains for transparent electrodes.

A front metal grid allows for a thinner transparent electrode layer. Although the grid unavoidably leads to shadow losses, the total loss due to parasitic absorption plus shadowing can be less than with a grid-less concept.

A further disadvantage is presented by the absorber layer in the thin film solar cell in particular when a perovskite layer is applied in the tandem geometry, because the conductivity that can be reached by the top electrode in combination with it's optical properties is rather poor in the state-of-the-art OPV and perovskite cells.

WO 2015/017885 discloses a stacked solar cell device, providing a photovoltaic device that has a photon receiving surface and a first single homojunction silicon solar cell. The first single homojunction silicon solar cell comprises two doped silicon portions with opposite polarities and has a first bandgap. The photovoltaic device further comprises a second solar cell structure that has an absorber material with a Perovskite structure and has a second bandgap that is larger than the first bandgap. The photovoltaic device is arranged such that each of the first and second solar cells absorb a portion of the photons that are received by the photon receiving surface.

It is an object of the present invention to overcome or mitigate at least one of the disadvantages of the prior art.

### Summary of the invention

The object is achieved by a tandem solar cell in accordance with claim 1

Advantageously, a tandem solar cell is created with a series connection between the bottom silicon wafer based solar cell and the top thin film solar cell structure that on the radiation receiving front surface of the tandem solar cell requires no external wiring that would shadow the front surface and reduce the area for capturing radiation.

According to an aspect, the invention provides the tandem solar cell as described above wherein the conductive element is arranged in a via hole extending from the first film surface to the second wafer surface.

According to an aspect, the invention provides the tandem solar cell as described above wherein the first film surface encompasses a third electrode layer of first polarity and the second film surface encompasses a fourth electrode layer of second polarity.

According to an aspect, the invention provides the tandem solar cell as described above wherein the solar cell comprises a recombination layer between the first electrode layer and the fourth electrode layer, for electrically coupling the first and fourth electrode layers.

According to an aspect, the invention provides the tandem solar cell as described above wherein the thin film solar cell structure comprises an absorber layer between the third and fourth electrode layers.

According to an aspect, the invention provides the tandem solar cell as described above wherein a front contacting structure is arranged on the first film surface, and the front contacting structure is electrically coupled to the at least one conductive element.

According to an aspect, the invention provides the tandem solar cell as described above wherein a rear surface contacting structure is arranged on the second wafer surface, isolated from the at least one contact pad on the second wafer surface.

According to an aspect, the invention provides the tandem solar cell as described above wherein the conductive element is isolated from at least the absorber layer and the fourth electrode layer by an isolating side wall, in addition, the conductive element is isolated from the recombination layer and the first electrode layer by the isolating side wall, and/or the conductive element is isolated from the third electrode layer by the isolating side wall, and/or the conductive element is isolated from the base conductivity layer and the second electrode layer by the isolating side wall.

According to an aspect, the invention provides the tandem solar cell as described above wherein at an edge of the tandem solar cell, the first electrode layer, the recombination layer, the fourth electrode layer, the absorber layer and the third electrode layer are covered by an edge isolation layer.

According to an aspect, the invention provides the tandem solar cell as described above wherein a second passivating tunnel layer is arranged between the second electrode layer and the base conductivity layer.

According to an aspect, the invention provides the tandem solar cell as described above wherein the absorber layer comprises one selected from a group comprising a perovskite material layer, a CIGS compound layer, a thin film silicon based layer, a III-V semiconductor based layer, a layer based on InP, InGaP, or GaAs compounds or based on nanowires, and/or the third electrode layer comprises a material selected from a group comprising, for a p-type electrode layer: p-type doped a-Si:H, p-type nano-crystalline-Si, micro-crystalline-Si and poly-crystalline-Si, spiro-OMeTAD, conjugated polymers, PEDOT, nickel oxide, molybdenum oxide or a p-type transparent conductive oxide and, for an n-type electrode layer: n-type doped a-Si:H, n-type nano-crystalline-Si, micro-crystalline-Si and poly-crystalline-Si, n-doped ZnO, TiO2, ITO, or another transparent conductive oxide, TCO, and/or the recombination layer comprises a material selected from a group comprising TCO, highly doped, degenerate, Si in amorphous, nano-crystalline, micro-crystalline or polycrystalline state, or n+ nano-crystalline SiOx:H, and/or the first electrode layer and/or the second electrode layer comprises a double layer of a doped polycrystalline silicon layer and a silicon-oxide based passivating tunnel layer.

Furthermore, the invention relates to a method for manufacturing a tandem solar cell, in accordance with claim 12.

According to an aspect, the invention provides the method as described above, further comprising: creating a conductive element in a via hole extending from the first film surface to the second wafer surface, arranging the conductive element in the via hole to extend from the first film surface to the second wafer surface.

According to an aspect, the invention provides the method as described above, comprising: providing an isolation the conductive element from at least the absorber layer and the fourth electrode layer by an isolating side wall, and/or isolating the conductive element from the recombination layer and the first electrode layer by the isolating side wall, and/or isolating the conductive element from the third electrode layer by the isolating side wall, and/or isolating the conductive element from the base conductivity layer and the second electrode layer by the isolating side wall.

According to an aspect, the invention provides the method as described above, comprising: at an edge of the tandem solar cell, covering the first electrode layer, the recombination layer, the fourth electrode layer, the absorber layer and the third electrode layer by an edge isolation layer.

According to an aspect, the invention provides the method as described above, comprising: forming a second passivating tunnel layer between the second electrode layer and the base conductivity layer.

Advantageous embodiments are further defined by the dependent claims.

### Brief description of drawings

Embodiments of the present invention will be described hereinafter, by way of example only, with reference to the accompanying drawings which are schematic in nature and therefore not necessarily drawn to scale. Furthermore, like reference signs in the drawings relate to like elements.
Figure 1 shows a cross-section of a tandem solar cell according to an example not belonging to the invention;
Figure 2 shows a cross-section of a tandem solar cell according to an example not belonging to the invention;
Figure 3 shows a cross-section of a tandem solar cell according to an example not belonging to the invention;
Figure 4 shows a cross-section of a tandem solar cell according to an example not belonging to the invention;
Figure 5 shows a cross-section of a tandem solar cell according to an example not belonging to the invention,
   and
Figure 6 shows a cross-section of a tandem solar cell according to an embodiment of the invention.

### Detailed description of embodiments

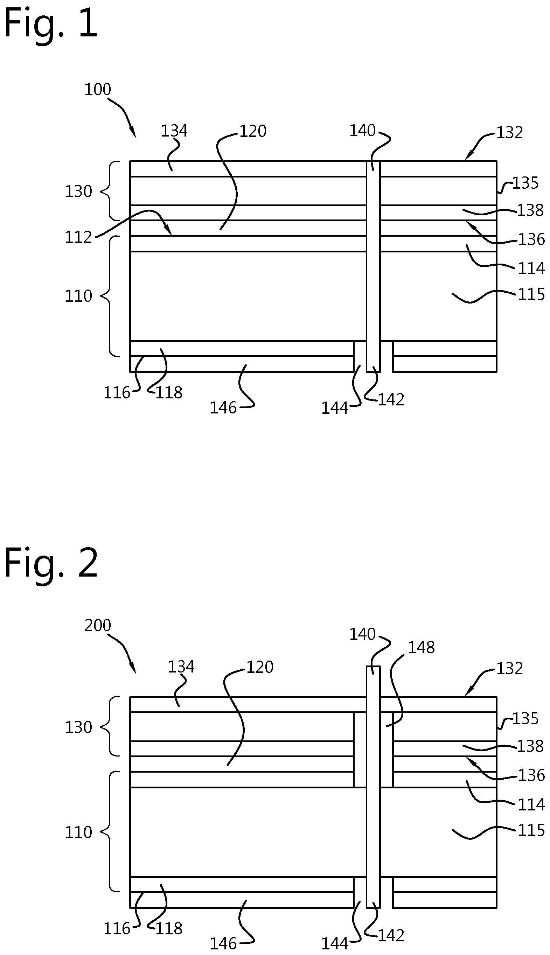

Figure 1 shows a cross-section of a tandem solar cell 100 according to an example not belonging to the invention.

The tandem solar cell 100 comprises a crystalline silicon wafer based solar cell 110 and a thin film solar cell structure 130.

Each of the solar cells 110, 130 comprises a front surface for receiving radiation as energy source, and a rear surface. On the front surface of each a top electrode is arranged, and a bottom electrode is arranged on the rear surface.

The silicon wafer based solar cell 110 comprises as top electrode a first electrode layer 114 of first polarity (i.e., a first doped layer of first conductivity type) on its front surface 112 and comprises as bottom electrode on its rear surface 116 a second electrode layer 118 of second polarity that is opposite to the first polarity (i.e., a second doped layer of second conductivity type). For example, the first conductivity type is p-type, then the second conductivity type is n-type (or vice versa).

Between the first and second electrode layers 114, 118, the silicon wafer based solar cell comprises a base conductivity layer 115.

The thin film solar cell structure 130 comprises as top electrode a third electrode layer 134 of first polarity (i.e., of first conductivity type) on its front surface 132 and comprises as bottom electrode on its rear surface 136 a fourth electrode layer 138 of second polarity that is opposite to the first polarity.

Between the third and fourth electrode layers 134, 138, the thin film solar cell structure comprises an absorber layer 135.

The thin film solar cell structure is stacked on the silicon wafer based solar cell with the bottom electrode (fourth electrode) 138 of the thin film solar cell structure 130 interfacing with the top electrode (first electrode) 114 of the silicon wafer based solar cell 110.

In between the first electrode layer 114 and the fourth electrode layer 138 a recombination layer 120 is arranged for electrically coupling the thin film solar cell structure 130 and the silicon wafer based solar cell 110.

In this manner, a series connection between the silicon wafer based solar cell 110 and the thin film solar cell structure 130 is obtained.

In addition, the tandem solar cell 100 is arranged as a back contacted solar cell arrangement. At least one conductive element 140 that extends through the stack of the silicon wafer based solar cell and the thin film solar cell structure, is arranged between the top electrode of the tandem solar cell, i.e., the third electrode layer 134 of the thin film solar cell 130 and the rear surface 116 of the silicon wafer based solar cell 110.

According to an example, the conductive element 140 is a conductive via structure, comprising a via hole that extends through the stack of the silicon wafer based solar cell and the thin film solar cell structure, and a conductive material that substantially fills the via hole.

The conductive element 140 is electrically coupled to the front third electrode layer 134. On the rear surface 116 a terminal or contact 142 is provided on the conductive element 140. The contact 142 is isolated from the rear surface electrode layer 118 by a gap 144 or by other insulating means.

In this manner, the conductive element 140 forms a conductive path between the front third electrode layer 134 and the contact 142.

On the rear surface 116 of the silicon wafer solar cell 110, a rear surface contacting structure 146 is provided as counter electrode relative to the contact 142. The rear surface contacting structure can e.g. comprise a full area metallization or a (printed) contact grid or any other contact structure known to the skilled in the art.

Advantageously, the tandem solar cell 100 according to the invention provides that on the radiation receiving front surface of the tandem solar cell 100 no external wiring is required that would shadow the front surface and reduce the area for capturing radiation.

In the example as shown in Figure 1, the conductive element 140 touches all electrode layers from both polarities from front surface to rear surface, which could cause internal short circuiting. According to the example the third electrode layer 134, the absorber layer 135, the fourth electrode layer 138, the first electrode layer 114 are all provided as layers with high resistivity, which restricts the short circuiting to a limited area near the conductive element 140. The rationale is that these layers do not require lateral conductivity. In the tandem solar cell, these layers are configured only to transport the current substantially in the direction from front to rear and thus they can be tuned for low conductivity, e.g. by limiting the thickness and/or by controlling the doping level, which both is also good for transparency of the layers (for transmitting the light that is not used by the top cell towards the bottom cell). Usually, a high conductivity in e.g. transparent oxides but also in silicon is accompanied by higher absorbance, caused by the free carriers that are necessary to provide the conductivity.

The conductive layers, the fourth electrode layer 138, the recombination layer 120, and the first electrode layer 114 can be extremely thin, e.g. between 1 and 200 nm. As an example, transparent conductive oxides as electrode materials in solar cells with lateral transport properties usually have sheet resistances in the order of 1-100 Ohm per square. If for the fourth electrode layer 138 a transparent conductive oxide is used, it can have a sheet resistance of 100-10000 Ohm per square or higher.

The tandem solar cell 100 can be manufactured in accordance with a method for manufacturing a tandem solar cell, comprising:
creating a silicon wafer based solar cell 110 having a first wafer surface 112 for receiving radiation and a second wafer 116 opposite the first wafer surface;
creating a thin film solar cell structure 130 having a first film surface 132 for receiving radiation and a second film surface 136 opposite the first film surface;
arranging the thin film solar cell on the silicon wafer based solar cell in such a manner that the second film surface 136 of the thin film solar cell structure 130 interfaces with the first wafer surface 112 of the silicon wafer based solar cell 110,
providing the stack of the silicon wafer based solar cell and the thin film solar cell structure with at least one conductive element 140 that extends through the stack between the first film surface 132 and the second wafer surface 118, and
providing the conductive element 140 with a contact 142 at the second wafer surface 118 to form a conductive path between the first film surface 132 and the contact 142. According to an example, the method comprises that the conductive element 140 is formed in a via hole.

Thus the method further comprises creating a via hole extending from the first film surface to the second wafer surface, and subsequently arranging the conductive element in the via hole to extend from the first film surface to the second wafer surface.

The via hole can be created by a "via drilling" method.

The thin film solar cell structure can be arranged on the top surface of the silicon based solar cell by creating the thin film solar cell using a layer-by-layer formation process on the top surface of the silicon wafer based solar cell. Alternatively, the thin film solar cell structure on the silicon wafer based solar cell can be created separately and then after its creation, stacked as a completed thin film solar cell structure on the top surface side (i.e. the first wafer surface side) of the silicon wafer based solar cell on top of the first electrode layer and the recombination layer.

Figure 2 shows a cross-section of a tandem solar cell 200 according to an example not belonging to the invention.

The tandem solar cell 200 has a same layered structure as the tandem solar cell 100 as described above with reference to Figure 1. In addition, the conductive element 140 is provided with an isolating sidewall 148 that isolates the conductive element 140 from at least the absorber layer 135, the fourth electrode layer 138, the recombination layer 120 and the first electrode layer 114. In this example the third electrode layer 134 is electrically connected with the conductive element 140.

Accordingly, in an example, the method of manufacturing comprises that prior to the creation of third electrode layer, a via hole is created in the stack of the absorber layer 135, the fourth electrode layer 138, the recombination layer 120 and the first electrode layer 114. After creating the via hole, the side walls of the absorber layer 135, the fourth electrode layer 138, the recombination layer 120 and the first electrode layer 114 are covered by isolating material 148. Next, the conductive element 40 is created in the via hole. Then, the third electrode layer 134 is formed on the absorber layer 135, in a manner that the third electrode layer 134 contacts the nearby end of the conductive element 140.

The isolation material 148 in the via hole can be deposited by printing processes, dispensing processes, etc. or through gas phase processes e.g. chemical vapor deposition (CVD) or atomic layer deposition (ALD) based techniques.

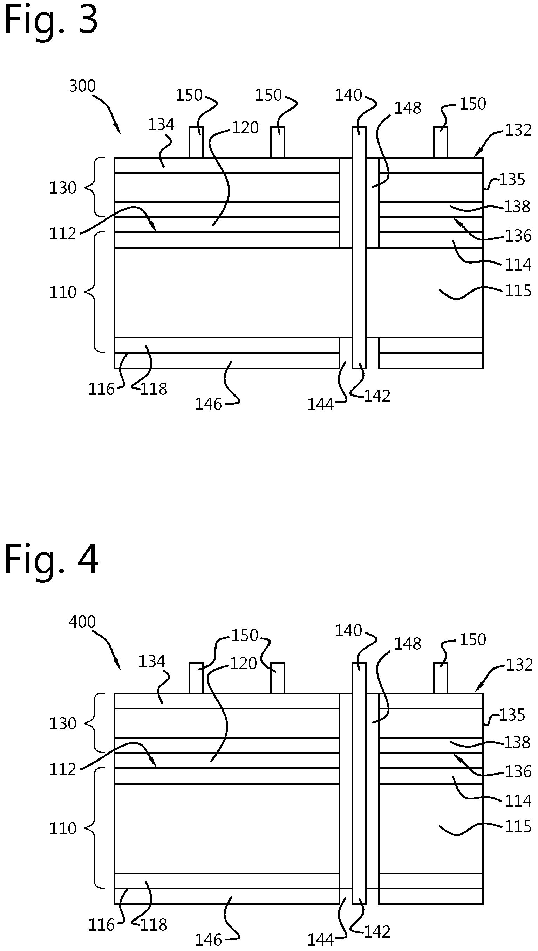

Figure 3 shows a cross-section of a tandem solar cell 300 according to an example not belonging to the invention.

The tandem solar cell 300 has a same layered structure as the tandem solar cell 100 as described above with reference to Figure 1. In addition, the conductive element 140 is provided with an isolating sidewall 148 that isolates the conductive element 140 from the third electrode layer 134, the absorber layer 135, the fourth electrode layer 138, the recombination layer 120, and the first electrode layer 114 of the silicon wafer.

According to this example, the third electrode layer 134 is provided with a front surface contacting structure 150 that electrically contacts the third electrode layer 134 and also electrically connects with the conductive element 140.

The front surface contacting structure 150 typically is a patterned mesh of conductive lines or arrays that are arranged on the third electrode layer 140. The mesh 150 may comprise a (screen or stencil) printed mesh or a silver based nanowire mesh, printed or applied otherwise, e.g. in a transparent matrix.

The front surface contacting structure 150 may be applied as well in one or more of the embodiments as described above with reference to Figure 1 or Figure 2.

Accordingly, in an example, the method of manufacturing comprises that a via hole is created in the stack of the third electrode layer 134, the absorber layer 135, the fourth electrode layer 138, the recombination layer 120, and the first electrode layer 114. After creating the via hole, the side walls of the third electrode layer 134, the absorber layer 135, the fourth electrode layer 138, the recombination layer 120 and the first electrode layer 114 are covered by isolating material 148. Next, the conductive element 140 is created in the via hole.

In a further step, a mesh 150 of electrode wires is formed on the third electrode layer, in such a manner that the mesh contacts the conductive element 140.

Alternative to the application of an isolation side wall 148, the conductive element 140 may comprise a plug paste material that is inherently non-contacting to one or more (preferably all) layers in the stack of the silicon wafer based solar cell 110 and the thin film solar cell structure 130.

Figure 4 shows a cross-section of a tandem solar cell 400 according to an example not belonging to the invention.

The tandem solar cell 400 according to this example has a same layered structure as the tandem solar cell 100 as described above with reference to Figure 1. In addition, the conductive element 140 is provided with an isolating sidewall 148 that isolates the conductive element 140 from at least the third electrode layer 134, the absorber layer 135, the fourth electrode layer 138, the recombination layer 120, the first electrode layer 114 and the base conductivity layer 115. In this example the third electrode layer 134 is provided with a front surface contacting structure 150 that electrically contacts the third electrode layer 134 and also electrically connects with the conductive element 140.

Accordingly, in an example, the method of manufacturing comprises that a via hole is created in the stack of the third electrode layer 134, the absorber layer 135, the fourth electrode layer 138, the recombination layer 120, the first electrode layer 114 and the base conductivity layer 115. After creating the via hole, the side walls of the third electrode layer 134, the absorber layer 135, the fourth electrode layer 138, the recombination layer 120, the first electrode layer 114 and the base conductivity layer 115 are covered by isolating material 148. Next, the conductive element 140 is created in the via hole.

In a further step, a mesh 150 of electrode lines is formed on the third electrode layer, in such a manner that the mesh contacts the conductive element 140.

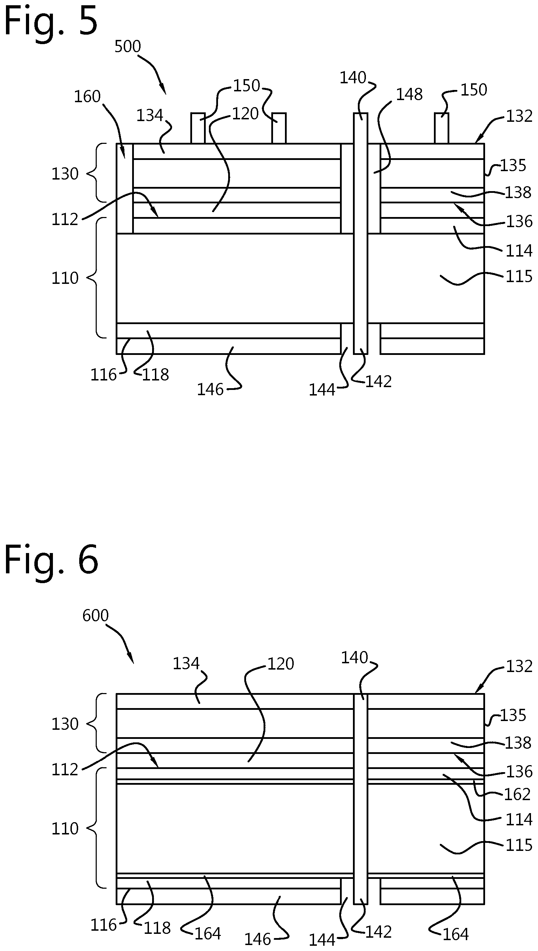

Figure 5 shows a cross-section of a tandem solar cell 500 according to an example not belonging to the invention.

The tandem solar cell 500 has a same layered structure as the tandem solar cell 300 as described above with reference to Figure 3. In addition, at a peripheral edge 502 of the tandem solar cell 500, an edge isolation wall 160 is arranged on the edges of the third electrode layer 134, the absorber layer 135, the fourth electrode layer 138, the recombination layer 120, and the first electrode layer 114 of the silicon wafer.

Accordingly, in an example, the method of manufacturing comprises that at a peripheral edge 502 of the tandem solar cell 500, the edge isolation wall 160 is created at the corresponding peripheral edges of the third electrode layer 134, the absorber layer 135, the fourth electrode layer 138, the recombination layer 120, and the first electrode layer 114.

Edge isolation is applied to prevent undesired electrical contact (shunting) between the top solar cell 130 and the bottom solar cell 110 at the edges, e.g. due to process issues, like overspill.

The edge isolation wall 160 may be created simultaneously with the isolating sidewall 148 in the via hole, but can also be created at a different stage of the manufacturing process, as will be appreciated by the person skilled in the art. According to an example, the edge isolation wall 160 is created by a printing process.

Also, it will be appreciated that the edge isolation wall 160 may be applied in combination of one or more of the other examples as described above with reference to Figures 1, 2, and 4.

Figure 6 shows a cross-section of a tandem solar cell 600 according to an embodiment of the invention.

The tandem solar cell 600 according to this embodiment has a same layered structure as the tandem solar cell 100 as described above with reference to Figure 1. In addition, the tandem solar cell 600 comprises a first passivating tunnel layer 162 which is arranged between the first electrode layer 114 and the base conductivity layer 115 of the silicon wafer based solar cell 110.

In an embodiment, the first passivating tunnel layer 162 is a thin layer based on silicon-oxide, SiOₓ:H or SiO₂, or intrinsic amorphous silicon a-Si:H, (thickness between 0.5 nm and 3 nm), or based on molybdenum oxide MoOx.

Additionally or alternatively to the first passivating tunnel layer, the silicon wafer based solar cell 110 may comprise a second passivating tunnel layer 164. The second passivating tunnel layer 164 is arranged between the second electrode layer 118 and the base conductivity layer 115 of the silicon wafer based solar cell 110.

In an embodiment, the method of manufacturing the tandem solar cell will comprise the creation of the first passivating tunnel layer 162 between the first electrode layer 114 and the base conductivity layer 115 during the manufacturing of the electrode layer 114 and the base conductivity layer 115 during the manufacturing of the silicon wafer based solar cell 110.

The person skilled in the art will appreciate that the first and/or second passivating tunnel layer(s) 162, 164 may also be applied in combination of one or more of the other embodiments as described with reference to Figures 1, 2, 3, 4 and 5.

The thin film solar cell structure may comprise as absorber layer a perovskite material layer. Alternatively, but not limited thereto, the absorber layer may comprise a CIGS compound, a thin film silicon based layer, a CdTe based layer, a III-V semiconductor based layer, or be based on InP, InGaP, or GaAs compounds or on nanowires.

The first and second electrode layers 114 and 118 may either be diffused, or ion-implanted, or be deposited, or be epitaxial layers or comprise a heterojunction, e.g. with doped amorphous silicon or combinations thereof, with either p-type or n-type doping, depending on the polarity. Deposited layers can either be doped amorphous silicon in the case of a heterojunction structure or doped nanocrystalline or polycrystalline silicon or combinations thereof.

A specifically beneficial combination is a silicon oxide based passivating tunnel layer 162 and/or 164 in combination with a doped polycrystalline based silicon first and/or second electrode layer 114 and/or 118. The polycrystalline silicon layer can be sufficiently doped to realize a carrier selective passivating electrode while having high optical transparency, especially in the wavelength region of interest to the bottom silicon solar cell of the tandem, and high lateral resistivity, which is specifically relevant for first electrode layer 114.

The third electrode layer 134 may comprise a material selected from a group comprising, for a p-type electrode layer: p-type doped a-Si:H, p-type nano-crystalline-Si, micro-crystalline-Si and poly-crystalline-Si, spiro-OMeTAD, conjugated polymers, PEDOT, nickel oxide, molybdenum oxide or a p-type transparent conductive oxide and, for an n-type electrode layer: n-type doped a-Si:H, n-type nano-crystalline-Si, micro-crystalline-Si and poly-crystalline-Si, n-doped ZnO, TiO₂, ITO, or another transparent conductive oxide, TCO.

Likewise, the fourth electrode layer 138 can be selected from the same materials as the third electrode layer 134, but for the opposite conductivity type / polarity type.

The recombination layer 120 may comprise a material selected from a group comprising TCO, highly doped (degenerate) Si (amorphous, nano-crystalline, micro-crystalline or polycrystalline) or n+ nano-crystalline SiOₓ:H or any other material that combines a sufficient transparency for incoming radiation with a sufficient recombination rate for charge carriers.

In case the silicon wafer based solar cell 110 would be a heterojunction type solar cell, the TCO layer that is usually part of the first electrode layer 114 can be combined with the recombination layer 120, or could function also as recombination layer.

The base conductivity layer 115 can be an intrinsic silicon semiconductor layer (i-type layer), or a relatively low doped p- or n-type layer with relatively low dopant level in comparison with the dopant level of either the first and/or the second electrode layer(s) 114, 118.

It will be understood that the tandem solar cell can comprise an anti-reflection layer (not shown) on top of the stack.

The skilled in the art will appreciate that the silicon wafer based solar cell may have either a polished surface or a textured surface on which the film solar cell structure is arranged.

In the foregoing description of the figures, the invention has been described with reference to specific embodiments thereof. It will however be evident that various modifications and changes may be made thereto without departing from the scope of the invention as summarized in the attached claims.

In addition, many modifications may be made to adapt a particular situation or material to the teachings of the invention without departing from the essential scope thereof. Therefore, it is intended that the invention not be limited to the particular embodiments disclosed, but that the invention will include all embodiments falling within the scope of the appended claims.

## Claims

1. A tandem solar cell (600) comprising a stack of a silicon wafer based solar cell (110) and a thin film solar cell structure (130);
the silicon wafer based solar cell having a first wafer surface (112) for receiving radiation and a second wafer surface (116) opposite the first wafer surface;
the thin film solar cell structure having a first film surface (132) for receiving radiation and a second film surface (136) opposite the first film surface;
the second film surface of the thin film solar cell structure interfacing with the first wafer surface of the silicon wafer based solar cell,
**characterized in that**
the stack of the silicon wafer based solar cell and the thin film solar cell structure being provided with at least one conductive element (140) that extends through the stack between the first film surface and the second wafer surface, and is provided with a contact pad (142) on the second wafer surface and forms a conductive path between the first film surface and the contact pad,
wherein the first wafer surface encompasses a first electrode layer (114) of first polarity and the second wafer surface encompasses a second electrode layer (118) of second polarity, the second polarity being opposite to the first polarity; the silicon wafer solar cell comprises a base conductivity layer (115) between the first and second electrode layers, and a passivating tunnel layer (162) is arranged between the first electrode layer (114) and the base conductivity layer.

2. The tandem solar cell according to claim 1, wherein the conductive element is arranged in a via hole extending from the first film surface to the second wafer surface.

3. The tandem solar cell according to claim 1, wherein the first film surface encompasses a third electrode layer (134) of first polarity and the second film surface encompasses a fourth electrode layer (138) of second polarity.

4. The tandem solar cell according to claim 3, wherein the solar cell comprises a recombination layer (120) between the first electrode layer and the fourth electrode layer, for electrically coupling the first and fourth electrode layers.

5. The tandem solar cell according to claim 3 or claim 4, wherein the thin film solar cell structure comprises an absorber layer (135) between the third and fourth electrode layers.

6. The tandem solar cell according to any one of the preceding claims, wherein a front contacting structure (150) is arranged on the first film surface, and the front contacting structure is electrically coupled to the at least one conductive element.

7. The tandem solar cell according to any one of the preceding claims, wherein a rear surface contacting structure (146) is arranged on the second wafer surface, isolated from the at least one contact pad on the second wafer surface.

8. The tandem solar cell according to claim 5 when dependent on claim 4, wherein the conductive element is isolated from at least the absorber layer and the fourth electrode layer by an isolating side wall (148);
in addition, the conductive element is isolated from the recombination layer and the first electrode layer by the isolating side wall.

9. The tandem solar cell according to claim 8, wherein in addition, the conductive element is isolated from the third electrode layer by the isolating side wall,
and/or
the conductive element is isolated from the base conductivity layer and the second electrode layer by the isolating side wall.

10. The tandem solar cell according to claim 5 when dependent on claim 3, wherein the conductive element is isolated from at least the absorber layer and the fourth electrode layer by an isolating side wall (148);
in addition, the conductive element is isolated from the third electrode layer by the isolating side wall.

11. The tandem solar cell according to claim 10, wherein in addition, the conductive element is isolated from the base conductivity layer and the second electrode layer by the isolating side wall.

12. The tandem solar cell according to claim 5, wherein the conductive element is isolated from at least the absorber layer and the fourth electrode layer by an isolating side wall (148);
in addition, the conductive element is isolated from the base conductivity layer and the second electrode layer by the isolating side wall.

13. The tandem solar cell according to any one of the preceding claims 1 - 12,
wherein at an edge of the tandem solar cell, any of the first electrode layer, the recombination layer, the fourth electrode layer, the absorber layer and the third electrode layer are covered by an edge isolation layer (160).

14. The tandem solar cell according to any one of the preceding claims 1 - 13,
wherein a second passivating tunnel layer (164) is arranged between the second electrode layer and the base conductivity layer.

15. The tandem solar cell according to claim 5 or any one of claims 6-14, when dependent on claim 5, wherein the absorber layer comprises one selected from a group comprising a perovskite material layer, a CIGS compound layer, a thin film silicon based layer, a III-V semiconductor based layer, a layer based on InP, InGaP, or GaAs compounds or based on nanowires
and/or
the third electrode layer comprises a material selected from a group comprising, for a p-type electrode layer: p-type doped a-Si:H, p-type nano-crystalline-Si, micro-crystalline-Si and poly-crystalline-Si, spiro-OMeTAD, conjugated polymers, PEDOT, nickel oxide, molybdenum oxide or a p-type transparent conductive oxide and, for an n-type electrode layer: n-type doped a-Si:H, n-type nano-crystalline-Si, micro-crystalline-Si and poly-crystalline-Si, n-doped ZnO, TiO₂, ITO, or another transparent conductive oxide, TCO,
and/or
the recombination layer comprises a material selected from a group comprising TCO, highly doped degenerate Si in amorphous, nano-crystalline, micro-crystalline or polycrystalline state, or n+ nano-crystalline SiOₓ:H,
and/or
the first electrode layer and/or the second electrode layer comprises a double layer of a doped polycrystalline silicon layer and a silicon-oxide based passivating tunnel layer.

16. A method for manufacturing a tandem solar cell (600), comprising:
creating a silicon wafer based solar cell (110) having a first wafer surface (112) for receiving radiation and a second wafer surface (116) opposite the first wafer surface;
arranging a thin film solar cell structure (130) having a first film surface (132) for receiving radiation and a second film surface (136) opposite the first film surface on the silicon wafer based solar cell in such a manner that the second film surface of the thin film solar cell structure interfaces with the first wafer surface of the silicon wafer based solar cell,
providing the stack of the silicon wafer based solar cell and the thin film solar cell structure with at least one conductive element (140) that extends through the stack between the first film surface and the second wafer surface, and
providing the conductive element with at least one contact pad (142) on the second wafer surface to form a conductive path between the first film surface and the contact pad,
creating in or on the first wafer surface a first electrode layer (114) of first polarity,
and creating in or on the second wafer surface a second electrode layer (118) of second polarity, the second polarity being opposite to the first polarity;
wherein the first wafer surface encompasses a first electrode layer of first polarity and the second wafer surface encompasses a second electrode layer of second polarity, the second polarity being opposite to the first polarity, and **characterized by** providing that the silicon wafer based solar cell comprises a base conductivity layer (115) between the first and second electrode layers and in that the method comprises forming a passivating tunnel layer (162) between the first electrode layer and the base conductivity layer.

17. The method according to claim 16, further comprising:
creating a conductive element in a via hole extending from the first film surface to the second wafer surface,
arranging the conductive element in the via hole to extend from the first film surface to the second wafer surface.

18. The method according to claim 17, comprising
creating in or on the first film surface a third electrode layer of first polarity, and in or on the second film surface a fourth electrode layer of second polarity and an absorber layer between the third and fourth electrode layers; providing an isolation of the conductive element from at least the absorber layer and the fourth electrode layer by an isolating side wall (148).

19. The method according to claim 18, comprising:
creating a recombination layer on the first electrode layer so as to be arranged in the tandem solar cell between the first electrode layer and the fourth electrode layer, for electrically coupling the first and fourth electrode layers;
isolating the conductive element from the recombination layer and the first electrode layer by the isolating side wall.

20. The method according to claim 18 or claim 19 comprising isolating the conductive element from the third electrode layer by the isolating side wall.

21. The method according to claim 18 or claim 19 or claim 20, comprising:
isolating the conductive element from the base conductivity layer and the second electrode layer by the isolating side wall.

22. The method according to claim 19, comprising:
at an edge of the tandem solar cell, covering any of the first electrode layer, the recombination layer, the fourth electrode layer, the absorber layer and the third electrode layer by an edge isolation layer (160).

23. The method according to any one of the preceding claims 16 - 22, comprising:
forming a second passivating tunnel layer (164) between the second electrode layer and the base conductivity layer.

## Patentansprüche

1. Tandemsolarzelle (600), umfassend einen Stapel aus einer Solarzelle (110) auf Siliziumwaferbasis und eine Dünnschichtsolarzellenstruktur (130);
wobei die Solarzelle auf Siliziumwaferbasis eine erste Waferoberfläche (112) zum Empfangen von Strahlung und eine zweite Waferoberfläche (116) gegenüber der ersten Waferoberfläche aufweist;
wobei die Dünnschichtsolarzellenstruktur eine erste Schichtoberfläche (132) zum Empfangen von Strahlung und eine zweite Schichtoberfläche (136) gegenüber der ersten Schichtoberfläche aufweist;
wobei die zweite Schichtoberfläche der Dünnschichtsolarzellenstruktur an die erste Waferoberfläche der Solarzelle auf Siliziumwaferbasis angrenzt,
**dadurch gekennzeichnet, dass**
der Stapel aus der Solarzelle auf Siliziumwaferbasis und der Dünnschichtsolarzellenstruktur mit mindestens einem leitfähigen Element (140) versehen ist, das sich durch den Stapel zwischen der ersten Schichtoberfläche und der zweiten Waferoberfläche erstreckt, und auf der zweiten Waferoberfläche mit einem Kontaktpad (142) versehen ist und einen leitfähigen Pfad zwischen der ersten Schichtoberfläche und dem Kontaktpad bildet,
wobei die erste Waferoberfläche eine erste Elektrodenschicht (114) erster Polarität umfasst und die zweite Waferoberfläche eine zweite Elektrodenschicht (118) zweiter Polarität umfasst, wobei die zweite Polarität der ersten Polarität entgegengesetzt ist; wobei die Solarzelle auf Siliziumwaferbasis eine Basiskonduktivitätsschicht (115) zwischen der ersten und der zweiten Elektrodenschicht umfasst, und eine passivierende Tunnelschicht (162) zwischen der ersten Elektrodenschicht (114) und der Basiskonduktivitätsschicht angeordnet ist.

2. Tandemsolarzelle nach Anspruch 1, wobei das leitfähige Element in einem Durchgangsloch angeordnet ist, das sich von der ersten Schichtoberfläche zu der zweiten Waferoberfläche erstreckt.

3. Tandemsolarzelle nach Anspruch 1, wobei die erste Schichtoberfläche eine dritte Elektrodenschicht (134) erster Polarität umfasst und die zweite Schichtoberfläche eine vierte Elektrodenschicht (138) zweiter Polarität umfasst.

4. Tandemsolarzelle nach Anspruch 3, wobei die Solarzelle eine Rekombinationsschicht (120) zwischen der ersten Elektrodenschicht und der vierten Elektrodenschicht umfasst, um die erste und die vierte Elektrodenschicht elektrisch zu koppeln.

5. Tandemsolarzelle nach Anspruch 3 oder Anspruch 4, wobei die Dünnschichtsolarzellenstruktur eine Absorberschicht (135) zwischen der dritten und vierten Elektrodenschicht umfasst.

6. Tandemsolarzelle nach einem der voranstehenden Ansprüche, wobei eine Frontkontaktstruktur (150) auf der ersten Schichtoberfläche angeordnet ist und die Frontkontaktstruktur elektrisch mit dem mindestens einen leitfähigen Element gekoppelt ist.

7. Tandemsolarzelle nach einem der vorstehenden Ansprüche, wobei eine Rückflächenkontaktstruktur (146) auf der zweiten Waferoberfläche angeordnet ist, isoliert von dem mindestens einen Kontaktpad auf der zweiten Waferoberfläche.

8. Tandemsolarzelle nach Anspruch 5, wenn abhängig von Anspruch 4, wobei das leitfähige Element durch eine isolierende Seitenwand (148) von mindestens der Absorberschicht und der vierten Elektrodenschicht isoliert ist;
zusätzlich ist das leitfähige Element durch die isolierende Seitenwand von der Rekombinationsschicht und der ersten Elektrodenschicht isoliert.

9. Tandemsolarzelle nach Anspruch 8, wobei das leitfähige Element zusätzlich von der dritten Elektrodenschicht durch die isolierende Seitenwand isoliert ist,
und/oder
das leitfähige Element durch die isolierende Seitenwand von der Basiskonduktivitätsschicht und der zweiten Elektrodenschicht isoliert ist.

10. Tandemsolarzelle nach Anspruch 5, wenn abhängig von Anspruch 3, wobei das leitfähige Element durch eine isolierende Seitenwand (148) von mindestens der Absorberschicht und der vierten Elektrodenschicht isoliert ist;
zusätzlich ist das leitfähige Element durch die isolierende Seitenwand von der dritten Elektrodenschicht isoliert.

11. Tandemsolarzelle nach Anspruch 10, wobei das leitfähige Element zusätzlich durch die isolierende Seitenwand von der Basiskonduktivitätsschicht und der zweiten Elektrodenschicht isoliert ist.

12. Tandemsolarzelle nach Anspruch 5, wobei das leitfähige Element durch eine isolierende Seitenwand (148) von mindestens der Absorberschicht und der vierten Elektrodenschicht isoliert ist;
zusätzlich ist das leitfähige Element durch die isolierende Seitenwand von der Basiskonduktivitätsschicht und der zweiten Elektrodenschicht isoliert.

13. Tandemsolarzelle nach einem der voranstehenden Ansprüche 1 - 12,
wobei an einem Rand der Tandemsolarzelle eine beliebige der ersten Elektrodenschicht, der Rekombinationsschicht, der vierten Elektrodenschicht, der Absorberschicht und der dritten Elektrodenschicht von einer Randisolationsschicht (160) bedeckt ist.

14. Tandemsolarzelle nach einem der voranstehenden Ansprüche 1 - 13,
wobei eine zweite passivierende Tunnelschicht (164) zwischen der zweiten Elektrodenschicht und der Basiskonduktivitätsschicht angeordnet ist.

15. Tandemsolarzelle nach Anspruch 5 oder einem der Ansprüche 6 - 14, wenn abhängig von Anspruch 5, wobei die Absorberschicht eines umfasst, ausgewählt aus einer Gruppe, die eine Perowskitmaterialschicht, eine CIGS-Verbindungs-Schicht, eine dünne Schicht auf Siliziumbasis, eine III-V-halbleiterbasierte Schicht, eine Schicht auf Basis von InP, InGaP oder GaAs-Verbindungen oder auf Basis von Nanodrähten umfasst
und/oder
die dritte Elektrodenschicht ein Material umfasst, das aus einer Gruppe ausgewählt ist, die für eine p-Typ-Elektrodenschicht Folgendes umfasst: p-Typ-dotiertes a-Si:H, p-Typ-nanokristallines Si, mikrokristallines Si und polykristallines Si, Spiro-OMeTAD, konjugierte Polymere, PEDOT, Nickeloxid, Molybdänoxid oder ein p-Typtransparentes leitfähiges Oxid, und für eine n-Typ-Elektrodenschicht Folgendes umfasst: n-Typ-dotiertes a-Si:H, n-Typ-nanokristallines Si, mikrokristallines Si und polykristallines Si, n-dotiertes ZnO, TiO₂, ITO oder ein anderes transparentes leitfähiges Oxid, TCO,
und/oder
die Rekombinationsschicht ein Material umfasst, das aus einer Gruppe ausgewählt ist, die TCO, hochdotiertes degeneriertes Si in amorphem, nanokristallinem, mikrokristallinem oder polykristallinem Zustand oder n+ nanokristallines SiOx:H umfasst,
und/oder
die erste Elektrodenschicht und/oder die zweite Elektrodenschicht eine Doppelschicht aus einer dotierten polykristallinen Siliziumschicht und einer auf Siliziumoxid basierenden passivierenden Tunnelschicht umfasst.

16. Verfahren zur Herstellung einer Tandemsolarzelle (600), umfassend:
Erzeugen einer Solarzelle (110) auf Siliziumwaferbasis mit einer ersten Waferoberfläche (112) zum Empfangen von Strahlung und einer zweiten Waferoberfläche (116) gegenüber der ersten Waferoberfläche;
Anordnen einer Dünnschichtsolarzellenstruktur (130) mit einer ersten Schichtoberfläche (132) zum Empfangen von Strahlung und einer der ersten Schichtoberfläche gegenüberliegenden zweiten Schichtoberfläche (136) auf der Solarzelle auf Siliziumwaferbasis derart, dass die zweite Schichtoberfläche der Dünnschichtsolarzellenstruktur an die erste Waferoberfläche der Solarzelle auf Siliziumwaferbasis angrenzt,
Versehen des Stapels aus der Solarzelle auf Siliziumwaferbasis und der Dünnschichtsolarzellenstruktur mit mindestens einem leitfähigen Element (140), das sich durch den Stapel zwischen der ersten Schichtoberfläche und der zweiten Waferoberfläche erstreckt, und
Versehen des leitfähigen Elements mit mindestens einem Kontaktpad (142) auf der zweiten Waferoberfläche, um einen leitfähigen Pfad zwischen der ersten Schichtoberfläche und dem Kontaktpad zu bilden,
Erzeugen einer ersten Elektrodenschicht (114) erster Polarität in oder auf der ersten Waferoberfläche,
und Erzeugen einer zweiten Elektrodenschicht (118) zweiter Polarität in oder auf der zweiten Waferoberfläche, wobei die zweite Polarität der ersten Polarität entgegengesetzt ist;
wobei die erste Waferoberfläche eine erste Elektrodenschicht erster Polarität umfasst und die zweite Waferoberfläche eine zweite Elektrodenschicht zweiter Polarität umfasst, wobei die zweite Polarität der ersten Polarität entgegengesetzt ist, und **gekennzeichnet durch** das Ausstatten der Solarzelle auf Siliziumwaferbasis, sodass diese eine Basiskonduktivitätsschicht (115) zwischen der ersten und der zweiten Elektrodenschicht umfasst und **dadurch, dass** das Verfahren das Ausbilden einer passivierenden Tunnelschicht (162) zwischen der ersten Elektrodenschicht und der Basiskonduktivitätsschicht umfasst.

17. Verfahren nach Anspruch 16, weiter umfassend:
Erzeugen eines leitfähigen Elements in einem Durchgangsloch, das sich von der ersten Schichtoberfläche zu der zweiten Waferoberfläche erstreckt,
Anordnen des leitfähigen Elements in dem Durchgangsloch, so dass es sich von der ersten Schichtoberfläche zu der zweiten Waferoberfläche erstreckt.

18. Verfahren nach Anspruch 17, umfassend:
Erzeugen einer dritten Elektrodenschicht erster Polarität in oder auf der ersten Schichtoberfläche, und einer vierten Elektrodenschicht zweiter Polarität in oder auf der zweiten Schichtoberfläche, und einer Absorberschicht zwischen der dritten und vierten Elektrodenschicht;
Bereitstellen einer Isolierung des leitfähigen Elements von zumindest der Absorberschicht und der vierten Elektrodenschicht durch eine isolierende Seitenwand (148).

19. Verfahren nach Anspruch 18, umfassend:
Erzeugen einer Rekombinationsschicht auf der ersten Elektrodenschicht, so dass sie in der Tandemsolarzelle zwischen der ersten Elektrodenschicht und der vierten Elektrodenschicht angeordnet ist, um die erste und die vierte Elektrodenschicht elektrisch zu koppeln;
Isolieren des leitfähigen Elements von der Rekombinationsschicht und der ersten Elektrodenschicht durch die isolierende Seitenwand.

20. Verfahren nach Anspruch 18 oder Anspruch 19, umfassend das Isolieren des leitfähigen Elements von der dritten Elektrodenschicht durch die isolierende Seitenwand.

21. Verfahren nach Anspruch 18 oder Anspruch 19 oder Anspruch 20, umfassend:
Isolieren des leitfähigen Elements von der Basiskonduktivitätsschicht und der zweiten Elektrodenschicht durch die isolierende Seitenwand.

22. Verfahren nach Anspruch 19, umfassend:
Bedecken einer beliebigen der ersten Elektrodenschicht, der Rekombinationsschicht, der vierten Elektrodenschicht, der Absorberschicht und der dritten Elektrodenschicht an einer Kante der Tandemsolarzelle durch eine Randisolationsschicht (160).

23. Verfahren nach einem der voranstehenden Ansprüche 16 - 22, umfassend:
Bilden einer zweiten passivierenden Tunnelschicht (164) zwischen der zweiten Elektrodenschicht und der Basiskonduktivitätsschicht.

## Revendications

1. Cellule solaire en tandem (600) comprenant un empilement d'une cellule solaire à base de tranche de silicium (110) et d'une structure de cellule solaire à film mince (130) ;
la cellule solaire à base de tranche de silicium présentant une première surface de tranche (112) pour recevoir un rayonnement et une seconde surface de tranche (116) opposée à la première surface de tranche ; la structure de cellule solaire à film mince présentant une première surface de film (132) pour recevoir un rayonnement et une seconde surface de film (136) opposée à la première surface de film ; la seconde surface de film de la structure de cellule solaire à film mince étant en interface avec la première surface de tranche de la cellule solaire à base de tranche de silicium,
**caractérisée en ce que**
l'empilement de la cellule solaire à base de tranche de silicium et de la structure de cellule solaire à film mince est pourvu d'au moins un élément conducteur (140) qui s'étend à travers l'empilement entre la première surface de film et la seconde surface de tranche, et est pourvu d'une plage de contact (142) sur la seconde surface de tranche et forme un trajet conducteur entre la première surface de film et la plage de contact,
dans laquelle la première couche de tranche englobe une première couche d'électrode (114) d'une première polarité et la seconde surface de tranche englobe une deuxième couche d'électrode (118) d'une seconde polarité, la seconde polarité étant opposée à la première polarité ;
la cellule solaire à tranche de silicium comprend une couche de conductivité de base (115) entre les première et deuxième couches d'électrode, et une couche tunnel de passivation (162) est agencée entre la première couche d'électrode (114) et la couche de conductivité de base.

2. Cellule solaire en tandem selon la revendication 1, dans laquelle l'élément conducteur est agencé dans un trou d'interconnexion s'étendant de la première surface de film à la seconde surface de tranche.

3. Cellule solaire en tandem selon la revendication 1, dans laquelle la première surface de film englobe une troisième couche d'électrode (134) de première polarité et la seconde surface de film englobe une quatrième couche d'électrode (138) de seconde polarité.

4. Cellule solaire en tandem selon la revendication 3, dans laquelle la cellule solaire comprend une couche de recombinaison (120) entre la première couche d'électrode et la quatrième couche d'électrode, pour coupler électriquement les première et quatrième couches d'électrode.

5. Cellule solaire en tandem selon la revendication 3 ou la revendication 4, dans laquelle la structure de cellule solaire à film mince comprend une couche absorbante (135) entre les troisième et quatrième couches d'électrode.

6. Cellule solaire en tandem selon l'une quelconque des revendications précédentes, dans laquelle une structure de contact avant (150) est agencée sur la première surface de film, et la structure de contact avant est couplée électriquement au au moins un élément conducteur.

7. Cellule solaire en tandem selon l'une quelconque des revendications précédentes, dans laquelle une structure de contact de surface arrière (146) est agencée sur la seconde surface de tranche, isolée de la au moins une plage de contact sur la seconde surface de tranche.

8. Cellule solaire en tandem selon la revendication 5 lorsqu'elle dépend de la revendication 4, dans laquelle l'élément conducteur est isolé d'au moins la couche absorbante et de la quatrième couche d'électrode par une paroi latérale isolante (148) ;
de plus, l'élément conducteur est isolé de la couche de recombinaison et de la première couche d'électrode par la paroi latérale isolante.

9. Cellule solaire en tandem selon la revendication 8, dans laquelle de plus l'élément conducteur est isolé de la troisième couche d'électrode par la paroi latérale isolante, et/ou
l'élément conducteur est isolé de la couche de conductivité de base et de la deuxième couche d'électrode par la paroi latérale isolante.

10. Cellule solaire en tandem selon la revendication 5 lorsqu'elle dépend de la revendication 3, dans laquelle l'élément conducteur est isolé d'au moins la couche absorbante et de la quatrième couche d'électrode par une paroi latérale isolante (148) ;
de plus, l'élément conducteur est isolé de la troisième couche d'électrode par la paroi latérale isolante.

11. Cellule solaire en tandem selon la revendication 10, dans laquelle de plus l'élément conducteur est isolé de la couche de conductivité de base et de la deuxième couche d'électrode par la paroi latérale isolante.

12. Cellule solaire en tandem selon la revendication 5, dans laquelle l'élément conducteur est isolé d'au moins la couche absorbante et de la quatrième couche d'électrode par une paroi latérale isolante (148) ;
de plus, l'élément conducteur est isolé de la couche de conductivité de base et de la deuxième couche d'électrode par la paroi latérale isolante.

13. Cellule solaire en tandem selon l'une quelconque des revendications précédentes 1 à 12, dans laquelle au niveau d'un bord de la cellule solaire en tandem, l'une quelconque de la première couche d'électrode, de la couche de recombinaison, de la quatrième couche d'électrode, de la couche absorbante et de la troisième couche d'électrode est recouverte par une couche d'isolation de bord (160).

14. Cellule solaire en tandem selon l'une quelconque des revendications précédentes 1 à 13, dans laquelle une seconde couche tunnel de passivation (164) est agencée entre la deuxième couche d'électrode et la couche de conductivité de base.

15. Cellule solaire en tandem selon la revendication 5 ou l'une quelconque des revendications 6 à 14, lorsqu'elle dépend de la revendication 5, dans laquelle la couche absorbante comprend une couche sélectionnée dans un groupe comprenant une couche de matériau de pérovskite, une couche de composé CIGS, une couche à base de silicium en film mince, une couche à base de semiconducteur III-V, une couche à base de composés InP, InGaP ou GaAs ou à base de nanofils
et/ou
la troisième couche d'électrode comprend un matériau choisi dans un groupe comprenant, pour une couche d'électrode de type p : a-Si :H dopé de type p, Si nano-cristallin de type p, Si micro-cristallin et Si poly-cristallin, spiro-OMeTAD, des polymères conjugués, PEDOT, oxyde de nickel, oxyde de molybdène ou un oxyde conducteur transparent de type p et, pour une couche d'électrode de type n : a-Si :H dopé de type n, Si nano-cristallin, Si micro-cristallin et Si poly-cristallin, ZnO dopé n, TiO₂, ITO, ou un autre oxyde conducteur transparent, TCO, et/ou
la couche de recombinaison comprend un matériau choisi dans un groupe comprenant du TCO, du Si dégénéré hautement dopé à l'état amorphe, nanocristallin, micro-cristallin ou polycristallin, ou n + SiOx:H nanocristallin, et/ou
la première couche d'électrode et/ou la deuxième couche d'électrode comprend une couche double constituée d'une couche de silicium polycristallin dopé et d'une couche tunnel de passivation à base d'oxyde de silicium.

16. Procédé de fabrication d'une cellule solaire en tandem (600), comprenant les étapes consistant à :
créer 'une cellule solaire à base de tranche de silicium (110) présentant une première surface de tranche (112) pour recevoir un rayonnement et une seconde surface de tranche (116) opposée à la première surface de tranche ;
agencer une structure de cellule solaire à film mince (130) présentant une première surface de film (132) pour recevoir un rayonnement et une seconde surface de film (136) opposée à la première surface de film sur la cellule solaire à base de tranche de silicium de telle sorte que la seconde surface de film de la structure de cellule solaire à film mince s'interface avec la première surface de tranche de la cellule solaire à base de tranche de silicium,
fournir à l'empilement de la cellule solaire à base de tranche de silicium et de la structure de cellule solaire à film mince au moins un élément conducteur (140) qui s'étend à travers l'empilement entre la première surface de film et la seconde surface de tranche, et
doter l'élément conducteur d'au moins une plage de contact (142) sur la seconde surface de tranche pour former un trajet conducteur entre la première surface de film et la plage de contact,
créer dans ou sur la première surface de tranche une première couche d'électrode (114) d'une première polarité, et
créer dans ou sur la seconde surface de tranche une deuxième couche d'électrode (118) d'une seconde polarité, la seconde polarité étant opposée à la première polarité ;
dans lequel la première couche de tranche englobe une première couche d'électrode d'une première polarité et la seconde surface de tranche englobe une deuxième couche d'électrode d'une seconde polarité, la seconde polarité étant opposée à la première polarité, et
**caractérisé en ce qu'**il prévoit que la cellule solaire à base de tranche de silicium comprend une couche de conductivité de base (115) entre les première et deuxième couches d'électrode et **en ce que** le procédé comprend la formation d'une couche tunnel de passivation (162) entre la première couche d'électrode et la couche de conductivité de base.

17. Procédé selon la revendication 16, comprenant en outre les étapes consistant à :
créer un élément conducteur dans un trou d'interconnexion s'étendant de la première surface du film à la seconde surface de tranche,
agencer l'élément conducteur dans le trou d'interconnexion pour qu'il s'étende de la première surface de film à la seconde surface de tranche.

18. Procédé selon la revendication 17, comprenant les étapes consistant à :
créer dans ou sur la première surface de film une troisième couche d'électrode de première polarité, et dans ou sur la seconde surface de film une quatrième couche d'électrode de seconde polarité, et une couche absorbante entre les troisième et quatrième couches d'électrode ;
fournir une isolation de l'élément conducteur à partir d'au moins la couche absorbante et la quatrième couche d'électrode par une paroi latérale isolante (148).

19. Procédé selon la revendication 18, comprenant les étapes consistant à :
créer une couche de recombinaison sur la première couche d'électrode de manière à être agencée dans la cellule solaire en tandem entre la première couche d'électrode et la quatrième couche d'électrode, pour coupler électriquement les première et quatrième couches d'électrode ;
isoler l'élément conducteur de la couche de recombinaison et de la première couche d'électrode par l'intermédiaire de la paroi latérale isolante.

20. Procédé selon la revendication 18 ou la revendication 19, comprenant l'étape consistant à isoler l'élément conducteur de la troisième couche d'électrode par l'intermédiaire de la paroi latérale d'isolation.

21. Procédé selon la revendication 18 ou la revendication 19 ou la revendication 20, comprenant l'étape consistant à :
isoler l'élément conducteur de la couche de conductivité de base et de la deuxième couche d'électrode par l'intermédiaire de la paroi latérale d'isolation.

22. Procédé selon la revendication 19, comprenant l'étape consistant à :
au niveau d'un bord de la cellule solaire en tandem, recouvrir l'une quelconque de la première couche d'électrode, de la couche de recombinaison, de la quatrième couche d'électrode, de la couche absorbante et de la troisième couche d'électrode par une couche d'isolation de bord (160).

23. Procédé selon l'une quelconque des revendications précédentes 16 à 22, comprenant l'étape consistant à :
former une seconde couche tunnel de passivation (164) entre la deuxième couche d'électrode et la couche de conductivité de base.
